(19) Europäisches Patentamt
European Patent Office
Office européen des brevets

(11) Numéro de publication: **0 083 885**
**B1**

# (12) FASCICULE DE BREVET EUROPEEN

(45) Date de publication du fascicule du brevet: **11.09.85**

(51) Int. Cl.[4]: **H 03 H 2/00**

(21) Numéro de dépôt: **82402343.6**

(22) Date de dépôt: **21.12.82**

## (54) Dispositif sélectif accordable à ondes magnétostatiques de volume.

(30) Priorité: **31.12.81 FR 8124561**

(43) Date de publication de la demande: **20.07.83 Bulletin 83/29**

(45) Mention de la délivrance du brevet: **11.09.85 Bulletin 85/37**

(84) Etats contractants désignés: **DE GB NL**

(56) Documents cités:
**EP - A - 0 022 700**
**FR - A - 2 290 786**

**IEEE MTT-S INTERNATIONAL MICROWAVE SYMPOSIUM DIGEST, 1979, pages 154-156, New York, USA J.M. OWENS et al.: "Magnetostatic wave reflective array filter"**
**IEEE MTT-S INTERNATIONAL MICROWAVE SYMPOSIUM DIGEST, 1979, pages 160-161, New York, USA J.D. ADAM: "A temperature stabilized magnetostatic wave device"**
**NACHRICHTEN ELEKTRONIK, vol. 34, no. 8, août 1980, pages 263-266, Heidelberg, DE. P. SCHMITT: "Signalverarbeitung mit akustischen Oberflächenwellen"**
**ULTRASONICS SYMPOSIUM PROCEEDINGS, 26-28**

(73) Titulaire: **THOMSON-CSF, 173, Boulevard Haussmann, F-75379 Paris Cedex 08 (FR)**

(72) Inventeur: **Hartemann, Pierre, THOMSON-CSF SCPI 173, bld Haussmann, F-75379 Paris Cedex 08 (FR)**
Inventeur: **Castera, Jean-Paul, THOMSON-CSF SCPI 173, bld Haussmann, F-75379 Paris Cedex 08 (FR)**
Inventeur: **Dupont, Jean-Marie, THOMSON-CSF SCPI 173, bld Haussmann, F-75379 Paris Cedex 08 (FR)**

(74) Mandataire: **Wang, Pierre et al, THOMSON-CSF SCPI 173, Bld Haussmann, F-75379 Paris Cedex 08 (FR)**

(56) Documents cités: (suite)
**septembre 1979, pages 836-840, New Orleans, USA R.L. ROSENBERG et al.: "Crossed-resonator saw filter: A temperature-stable wider-band filter on quartz"**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

BUNDESDRUCKEREI BERLIN

## Description

La présente invention se rapporte aux dispositifs sélectifs accordables basés sur l'émission et la réception d'ondes magnétostatiques de volume progressives. Ces ondes sont généralement propagées par une couche magnétique déposée sur un substrat non magnétique. Les caractéristiques sélectives sont obtenues en formant à la surface de la couche magnétique des cavités résonantes délimitées par des réseaux de sillons ou de régions filamentaires ayant subi une implantation ionique. Le couplage ondulatoire en cascade de deux cavités résonantes munies chacune d'un microruban permet de transmettre sélectivement un signal électrique à haute fréquence dans une plage de fréquence très étroite. On peut déplacer cette plage pour réaliser un accord en jouant sur l'intensité d'un champ magnétique de direction perpendiculaire au plan de la couche magnétique.

Les ondes magnétostatiques de volume progressives ont des caractéristiques de propagation isotropes dans le plan de la couche magnétique et par rapport aux ondes magnétostatiques de surface elles offrent l'avantage d'un niveau de saturation plus élevé. Si l'on s'avise de réaliser un dispositif sélectif accordable en plaçant dans une cavité résonante un microruban émetteur et un microruban récepteur, on obtient bien une pointe de résonance à une fréquence donnée, mais le couplage direct qui s'établit entre les microrubans fait que les pertes d'insertion observées au voisinage de la résonance sont à peine plus importantes que celles que l'on observe au sommet de la pointe de résonance.

En disposant en cascade deux cavités résonantes délimitées par des réseaux réflecteurs parallèles et équipées chacune d'un microruban, on peut isoler par filtrage un mode commun, afin qu'une seule pointe de résonance soit observée dans un intervalle de fréquences important. Cependant, les pertes d'insertion de part et d'autre de cette pointe de résonance présentent un recul relativement faible par rapport au sommet de la pointe de résonance. Ceci résulte d'un découplage insuffisant entre les microrubans pour les fréquences qui s'écartent de la fréquence de résonance.

Le caractère unidirectionnel de la propagation des ondes magnétostatiques de surface permet d'obtenir un meilleur recul des pertes d'insertion pour les fréquences situées hors résonance, mais au prix d'une limitation en puissance et d'une dérive en température positive plus difficile à compenser.

En vue de pallier les inconvénients mentionnés ci-dessus tout en obtenant un recul sensible des pertes d'insertion aux fréquences en dehors de la résonance, l'invention prévoit d'utiliser des ondes magnétostatiques de volume progressives en mettant à profit l'omnidirectionnalité de ces ondes, le bon niveau de saturation aux basses fréquences et une plus grande facilité de compensation des dérives thermiques. Le dispositif obtenu peut aussi bien fonctionner comme filtre que comme boucle dans un montage oscillateur.

Par ailleurs, dans le domaine des ondes magnétostatiques, la demande de brevet européen EP-A-0 022 700 décrit un dispositif d'échange d'énergie, à l'aide d'un coupleur, entre deux cavités résonantes disposées parallèlement. L'invention concerne un dispositif d'échange d'énergie entre deux cavités résonantes dont les axes ne sont pas parallèles.

L'invention a donc pour objet un dispositif sélectif accordable à ondes magnétostatiques de volume comprenant une couche magnétique portée par un substrat non magnétique, des moyens de polarisation de ladite couche perpendiculairement à sa face libre, deux cavités résonantes à réseaux formées sur ladite couche magnétique et deux microrubans agencés respectivement dans lesdites cavités résonantes, afin de constituer l'entrée et la sortie électrique dudit dispositif, caractérisé en ce que les axes respectifs desdites cavités résonantes à réseaux se recoupent dans une région de ladite couche où est situé un réseau de renvoi d'énergie dont les éléments sont agencés pour renvoyer le maximum d'énergie incidente à la fréquence d'accord du dispositif, chaque cavité résonante à réseau comportant un réseau réflecteur d'extrémité et un réseau semireflecteur intercalé entre ledit réseau de renvoi d'énergie et le réseau réflecteur d'extrémité correspondant.

L'invention sera mieux comprise au moyen de la description ci-après et des figures annexées parmi lesquelles:

La figure 1 est une vue isométrique d'un dispositif sélectif accordable à ondes magnétostatiques de type connu.

Les figures 2 et 3 sont des diagrammes explicatifs.

La figure 4 est une vue isométrique partielle d'un exemple de réalisation de dispositif selon l'invention.

La figure 5 est une vue isométrique d'ensemble du dispositif selon l'invention.

La figure 6 est une vue en plan d'un fragment de plaquette telle qu'illustrée sur la figure 4.

Sur la figure 1, on peut voir un résonateur à deux portes 4 et 5 basé sur l'excitation et la captation d'ondes magnétostatiques.

Ce dispositif se compose par exemple d'un substrat non-magnétique 1 en grenat de gadolinium et gallium (GGG) à la surface duquel a été déposée par épitaxie en phase liquide une couche magnétique 2 de grenat d'yttrium et de fer (YIG). Un repère trirectangle Oxyz est représenté sur la figure 1 avec son plan oxy parallèle à la surface libre de la couche 2. L'épaisseur de la couche magnétique 2 est typiquement de 22 microns. Des moyens magnétiques inducteurs non représentés sur la figure 1 soumettent la couche magnétique 2 à un champ magnétique de polarisation de direction parallèle à l'axe z.

Dans ces conditions, on sait que la couche 2 peut servir de milieu de propagation d'ondes magnétostatiques de volume progressives (OMVF). Les caractéristiques de ces ondes sont les mêmes pour toutes les directions du plan xoy et elles dépendent de l'intensité du champ magnétique de polarisation. Un microruban rectiligne conducteur 6 reliant la porte 4 à une connexion de masse est parcouru par un couranrt à haute fréquence et vu qu'il est déposé sur la surface 3 de la couche 2, il engendre l'émission d'ondes magnétostatiques à fronts d'ondes rectilignes dans les directions positive et négative de l'axe x. Les ondes magnétostatiques émises interagissent avec deux réseaux 10 dont les traits 15 sont orientés parallèlement à l'axe oy.

A titre d'exemple non limitatif, sur la figure 1 les traits 15 sont en fait des sillons pratiqués dans la couche magnétique 2 par usinage ionique. La fonction de ces traits étant de créer une rupture d'impédance destinée à réfléchir localement les ondes magnétostatiques, on peut également envisager de créer des régions modifiées par implantation ionique ou de recoucrir la couche 2 d'un support non magnétique muni d'un réseau de bandes conductrices induisant un effet réflecteur similaire. Le pas p des réseaux 10 est choisi en fonction de la longueur d'onde $\lambda$ des ondes magnétostatiques. Pour une valeur $\lambda_0$, chaque réseau 10 présente globalement la réflectivité maximale si $2p = k\lambda_0$ avec $k = 1, 2, 3, \ldots$ etc. La largeur d d'un trait de réseau 15 fixe le rapport d/p. On peut jouer sur ce rapport pour amoindrir la réflectivité du réseau à une longueur d'onde sous multiple de celle pour laquelle la réflectivité maximale est recherchée.

Dans le cas de la figure 1, on peut par exemple supposer que $p = \lambda_0/2$, ce qui revient à s'imposer une fréquence d'onde magnétostatique f(H) pour chaque intensité du champ magnétique H de polarisation de la couche 2.

Sur la figure 1, les réseaux 10 délimitent une cavité de résonance dans laquelle le microruban 6 crée un régime d'ondes stationnaires à la fréquence f(H) mentionnée ci-dessus. En agençant dans cette cavité un microruban conducteur 7 reliant la connexion de masse à la porte 5, on peut disposer d'un courant électrique dont l'intensité est maximale pour cette fréquence. Cette intensité correspond à une pointe de résonance due aux propriétés de la cavité, mais l'effet de réjection des fréquences en dehors de la résonance n'est que de 3 à 4 dB comme l'illustre la figure 2. La courbe 101 de la figure 2 représente la caractéristique de transfert pour une valeur de réglage du champ magnétique de polarisation. Cette courbe donne les pertes d'insertion A en fonction de la fréquence f du signal électrique transmis entre les portes 4 et 5. On note que la pointe de résonance 100 est environnée de régions où les pertes d'insertion sont faiblement majorées. Ceci résulte en partie du couplage direct entre les microrubans 6 et 7 et en partie du fait que les réseaux sont de moins en moins réfléchissants lorsqu'on s'éloigne de la fréquence de résonance. A titre indicatif, la figure 1 illustre la largeur b des microrubans qui peut être de l'ordre de 10% de la longueur d'onde et la profondeur h des sillons 15 qui est de l'ordre d'un pourcent de l'épaisseur e de la couche magnétique.

Pour obtenir une caractéristique de transfert améliorée telle qu'illustrée sur la figure 3, l'invention propose de mettre en œuvre deux cavités de résonance équipées chacune d'un seul microruban et d'échanger entre ces cavités des ondes magnétostatiques de volume progressives réfléchies sélectivement et sous incidence oblique par un réseau intermédiaire.

Sur la figure 4, on peut voir la partie centrale d'un dispositif selon l'invention. Les mêmes références désignent les mêmes éléments que sur la figure 1.

Le microruban 6 est logé dans une cavité de résonance délimitée par un réseau réflecteur 10 et un réseau partiellement réflecteur 12. L'axe de cette cavité est parallèle à ox. Le microruban 6 est relié à une métallisation 8 constituant une charge électrique d'extrêmité. Le microruban 7 est logé dans une autre cavité de résonance délimitée par un réseau réflecteur 11 et un réseau partiellement réflecteur 13. Une métallisation 9 sert de terminaison au microruban 7. Les sillons 17 constituent les traits du réseau 11 et du réseau 13. Cette autre cavité de résonance a son axe parallèle à l'axe oy. Les deux cavités de résonance sont agencées de telle façon que leurs axes se recoupent dans une région où s'étend un réseau 14 formé de traits rectilignes 16 parallèles à la bissectrice extérieure de l'angle xoy. L'angle xoy n'a nul besoin d'être un angle droit.

Le réseau 14 sert à la fois de moyen de couplage et de découplage. Lorsque la fréquence de l'onde magnétostatique est celle sélectionnée par les deux cavités résonantes 10—12 et 11—13, le réseau 14 est dimensionné pour réfléchir le mieux possible les ondes qui émergent du réseau 12 pour les renvoyer vers le réseau 13. Ce mode de fonctionnement définit une pointe de résonance 100 avec une perte d'insertion minimale en son centre. Lorsque la fréquence des ondes magnétostatiques s'éloigne de cette condition, le réseau 14 réalise un découplage efficace des cavités de résonance 10—12 et 11—13.

En effet, la majeure partie de l'énergie qui émerge de la cavité 10—12 tend à franchir le réseau 14 sans subir le changement de direction illustré sur la figure 4 à l'emplacement du réseau 14. Ceci assure une augmentation sensible des pertes d'insertion de part et d'autre de la pointe de résonance 100, comme illustré sur la figure 3. Cette augmentation des pertes d'insertion est telle que la résonance en harmonique 102 devient visible sur la figure 3, mais cette pointe indésirable peut être combattue en choisissant convenablement le facteur de forme d/p ou en substituant aux microrubans 6 et 7 des transducteurs en épingle comme illustré sur la figure 6. La figure 6 est une vue en plan indiquant schématiquement les principales cotes à respecter dans un exemple de réalisation.

A titre purement illustratif, la fonction de transfert illustrée sur la figure 3 a pu être obtenue en partant d'un substrat de GGG, sur lequel on a fait croître par épitaxie en phase liquide une couche de YIG de 22 microns. Sur cette couche 2, on a déposé par pulvérisation de l'aluminium pour former les microrubans 6 et 7 de largeur b = 30 microns. Les réseaux 10 et 11 sont réalisés par usinage ionique en vue d'obtenir un pouvoir réflecteur aussi élevé que possible à la longueur d'onde $\lambda = 300$ microns. Ils sont constitués de 50 sillons, chacun avec un rapport h/e = 0,8% et un pas $p_1$ de 150 microns. Ces valeurs correspondent à une absorption en transmission de — 22 dB, soit, si l'on néglige les pertes, à un coefficient de réflexion en amplitude de R = 99,7%.

Le réseau intermédiaire de renvoi 14 fonctionne en incidence oblique et doit présenter un pas $p_2$ supérieur au pas $p_1$. En supposant que les axes des deux cavités forment un angle $\theta$, le pas $p_2$ du réseau 14 est donné par la relation:

$$p_2 = \frac{\lambda}{2 \cos \theta/2}$$

où $\lambda$ est la longueur d'onde à laquelle la réflexion Bragg est maximale.

Avec $\theta = \pi/2$ et $\lambda = 300$ microns, on trouve $p_2 = 212$ microns. Le réseau 14 sera par exemple constitué de 20 sillons ayant une profondeur relative h/e = 0,8%, ce qui correspond à une absorption de —8,75 dB et à un coefficient de réflexion en amplitude R = 93,1%. Restent les réseaux 12 et 13 qui sont formés chacun de 10 sillons au pas $p_1 = 150$ microns avec une profondeur relative h/e = 0,8%. Le pouvoir d'absorption par le réseau 12 ou le réseau 13 est —4,4 dB soit un coefficient de réflexion R = 79,8% et un coefficient de transmission T = 60,2%. Le coefficient de transmission de l'ensemble des réseaux 12 et 13 est dans ce cas égal à 36,3%.

La courbe de la figure 3 est applicable à cet exemple numérique. Les pertes d'insertion minimales s'élèvent à 14 dB, le coefficient de qualité est de 350 et la réjection des fréquences en dehorst de la résonance est de 23 dB.

En substituant aux microrubans 6 et 7 de la figure 4, le transducteur 23 de la figure 6 qui est formé par un dipôle replié de pas $p_3 = \lambda/2$, on peut faire disparaître la résonance 102 et augmenter les pertes d'insertion aux basses fréquences.

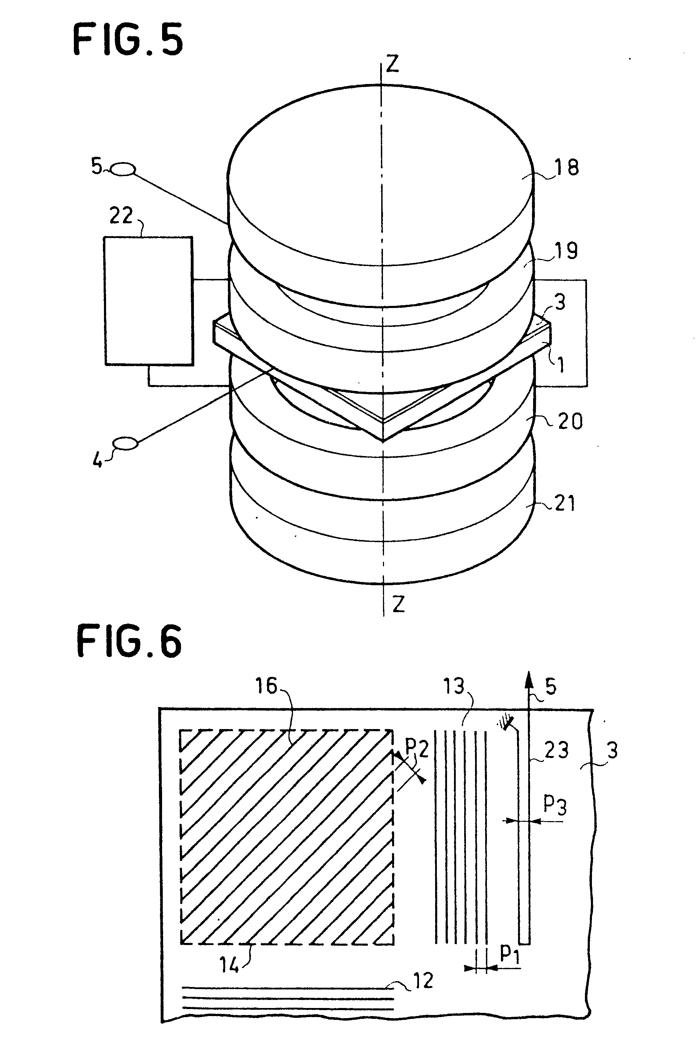

Le dispositif complet représenté à la figure 5 peut être utilisé comme filtre accordable ou comme boucle d'un oscillateur accordable. Outre les éléments de la figure 4 dont les références 1, 3, 4 et 5 sont rappelées, il comporte deux bobines 19 et 20 encadrant le substat 1. Ces bobines forment un bobinage de Helmholtz destiné à créer un champ magnétique uniforme de réglage de la fréquence de résonance. Le générateur 22 fait circuler un courant d'intensité réglable dans le bobinage de Helmholtz 19—20. Des aimants permanents 18 et 21 sont également prévus pour créer une aimantation permanente de direction parallèle à l'axe ZZ. La dérive en température des ondes magnétostatiques de volume progressives est telle qu'on peut la compenser par la dérive thermique propre des aimants permanents 18 et 21.

Sans s'écarter du domaine de la présente invention, il y a lieu de signaler que les deux cavités de résonance peuvent être le siège d'un nombre plus ou moins important de modes d'ondes stationnaires et que l'un d'entre eux peut être sélectionné en adoptant des longueurs de cavités telles que les autres modes soient rejetés. Il faut encore signaler que certaines cavités de résonance sont constituées par deux réseaux qui se rejoignent, le microruban étant disposé entre deux traits de réseau vers le milieu de la structure. Enfin, l'invention s'applique également à une structure dans laquelle les éléments de réseaux, au lieu d'être rectilignes seraient incurvés par rapport à un centre.

Ainsi, deux cavités résonantes ayant des réseaux dont les traits sont incurvés avec un centre commun situé dans leur prolongement pourraient coopérer avec un réseau de renvoi 14 dont les traits seraient formés de plots réflecteurs agencés pour fournir un maximum de réflectivité à une longeur d'onde prédéterminée.

Grâce au recul des pertes d'insertion autor de la pointe de résonance, le dispositif selon l'invention se prête également à la mesure du champ magnétique.

Pour terminer, il opportun de signaler que les traits des réseaux peuvent être obtenus sous la forme de sillons par une attaque chimique de la couche magnétique à travers un masque de résine. On peut également envisager une attaque chimique sélective postérieure à un bombardement ionique de la couche magnétique, ce qui sans l'aide d'un masque permet de réaliser une gravure en relief.

**Revendications**

1. Dispositif sélectif accordable à ondes magnétostatiques de volume comprenant une couche magnétique (2) portée par un substrat non magnétique (1), des moyens de polarisation de ladite couche (2) perpendiculairement à sa face libre, deux cavités résonantes à réseaux (10, 12, 11, 13) formées sur ladite couche magnétique (2) et deux microrubans (6, 7) agencés respectivement dans lesdites cavités résonantes, afin de constituer l'entrée (4) et la sortie (5) électrique dudit dispositif, caractérisé en ce que les axes respectifs desdites cavités résonantes à réseaux (10, 12, 11, 13) se recoupent dans une région de ladite couche (2) où est situé un réseau de renvoi d'énergie (14) dont les éléments (16) sont agencés pour renvoyer le maximum d'énergie incidente à la fréquence d'accord du dispositif, chaque cavité résonante à réseau (10, 11, 12, 13) comportant un réseau réflecteur d'extrêmité (10, 11) et un réseau semiréflecteur (12, 13) intercalé entre ledit réseau de renvoi d'énergie (14) et le réseau réflecteur d'extrêmité correspondant (10, 11).

2. Dispositif selon la revendications 1, caractérisé en ce que les axes desdites cavités forment entre eux un angle $\theta$; le pas $p_2$ dudit réseau de renvoi d'énergie (14) étant égal à $\lambda/2 \cos \theta/2$, où $\lambda$ est la longueur d'onde d'accord desdites cavités résonantes; les éléments (16) dudit réseau de renvoi étant alignés selon la bissectrice extérieure de l'angle $\theta$.

3. Dispositif selon la revendication 2, caractérisé en ce que l'angle $\theta$ est égal à $\pi/2$.

4. Dispositif selon l'une quelconque des revendications 1 à 3, caractérisé en ce que le facteur de forme d/p desdits réseaux (10, 11, 12, 13, 14) est choisi pour accroître les pertes d'insertion aux longueurs d'ondes sous multiple de la longueur d'onde $\lambda$ d'accord desdites cavités.

5. Dispositif selon l'une quelconque des revendications 1 à 4, caractérisé en ce que les microrubans (6, 7) sont repliés en forme de boucle (23) à deux éléments rayonnants rectilignes écartés de $\lambda/2$.

6. Dispositif selon l'un quelconque des revendications 1 à 5, caractérisé en ce que lesdites cavités (10, 11, 12, 13) ont les mêmes caractéristiques de filtrage.

7. Dispositif selon l'une quelconque des revendications 1 à 5, caractérisé en ce que lesdites cavités ont des caractéristiques de filtrage multimode distinctes ayant un mode de résonance commun.

8. Dispositif selon l'une quelconque des revendications 1 à 7, caractérisé en ce que lesdits moyens de polarisation (18, 19, 20, 21) créent un champ magnétique d'intensité ajustable autor d'une valeur de repos.

9. Dispositif selon la revendication 8, caractérisé en ce que la dérive thermique inhérente aux ondes magnétostatiques de volume progressive est compensée par la dérive thermique propre à ladite valeur de repos.

10. Dispositif selon la revendication 9, caractérisé en ce que ladite valeur de repos est déterminée par des aimants permanents appartenant aux moyens de polarisation de la couche (2).

11. Dispositif selon l'une quelconque des revendications précédentes, caractérisé en ce que le substrat non magnétique (1) est un grenat de gadolinium et de gallium; la couche (2) étant une couche de grenat d'yttrium et de fer épitaxiée en phase liquide à la surface dudit substrat (1).

12. Dispositif selon l'une quelconque des revendications précédentes, caractérisé en ce que lesdits réseaux (10, 11, 12, 13, 14) sont matérialisés par usinage ionique de la surface de ladite couche (2).

13. Dispositif selon l'une quelconque des revendication précédentes, caractérisé en ce que lesdits réseaux (10, 11, 12, 13, 14) sont matérialisés par implantation ionique de ladite couche (2).

14. Dispositif selon la revendication 13, caractérisé en ce qu'une attache chimique sélective assure la formation de réseaux en relief.

15. Dispositif selon l'une quelconque des revendications 1 à 11, caractérisé en ce que lesdits réseaux sont obtenus par attaque chimique au travers d'un masque.

**Patentansprüche**

1. Abstimmbare selektive magneto-statische Raumwellenvorrichtung, mit einer auf einer nichtmagnetischen Schicht (1) angeordneten magnetischen Schicht (2), mit Mitteln zum Polarisieren der magnetischen Schicht (2) in einer zu deren freier Oberfläche senkrechten Richtung, mit zwei in der magnetischen Schicht (2) ausgebildeten Resonanznetz-Ausnehmungen (10, 12, 11, 13), sowie mit zwei in je einer der Resonanzausnehmungen angeordneten Mikrobändern (6, 7), die den elektrischen Eingang (4) und Ausgang (5) der Vorrichtung bilden, dadurch gekennzeichnet, daß die Achse der Resonanz-Ausnehmungen (10, 12, 11, 13) sich in einer Zone der magnetischen Schicht (2) schneiden, in welcher ein Energiereflexionsnetz (14) angeordnet ist, dessen Bestandteile (16) derart ausgebildet sind, daß sie ein Maximum an empfangener Energie mit der Abstimmungsfrequenz der Vorrichtung reflektieren, wobei jede Netzausnehmung (10, 11, 12, 13) ein Endreflexionsnetz (10, 11) und ein zwischen dem Energiereflexions- (14) und dem entsprechenden Endreflexionsnetz (10, 11) angeordnetes Halbreflexionsnetz (12, 13) aufweist.

2. Vorrichtung nach Anspruch 1, dadurch gekennzeichnet, daß die Achsen der Ausnehmungen einen Winkel $\theta$ einschließen, wobei die Teilung $P_2$ des Energieumleitungsnetzes (14) gleich $\lambda/2 \cos \theta/2$ ist, wo $\lambda$ die Abstimmwellenlänge der Resonanzausnehmungen darstellt, während die Bauteile (16) des Reflexionsnetzes auf die äußere Winkelhalbierenden des Winkels $\theta$ ausgerichtet sind.

3. Vorrichtung nach Anspruch 2, dadurch gekennzeichnet, daß der Winkel $\theta$ gleich $\pi/2$ ist.

4. Vorrichtung nach einem der Ansprüche 1 bis 3, dadurch gekennzeichnet, daß der Formfaktor d/p der Netze (10, 11, 12, 13, 14) derart gewählt ist, daß die Einschaltungsverluste für ein Mehrfaches der Abstimmungswellenlänge $\lambda$ der Ausnehmungen darstellende Wellenlängen erhöht werden.

5. Vorrichtung nach einem der Ansprüche 1 bis 4, dadurch gekennzeichnet, daß die Mikrobänder (6, 7) in Form von im Abstand $\lambda/2$ angeordneten geradlinigen Strahlelementen schleifenförmig (23) gebogen sind.

6. Vorrichtung nach einem der Ansprüche 1 bis 5, dadurch gekennzeichnet, daß die Ausnehmungen (10, 11, 12, 13) gleiche Filterkennwerte besitzen.

7. Vorrichtung nach einem der Ansprüche 1 bis 5, dadurch gekennzeichnet, daß die Ausnehmungen bei einem gemeinsamen Resonanzmodus unterschiedliche Mehrtypenfilterkennwerte besitzen.

8. Vorrichtung nach einem der Ansprüche 1 bis 7, dadurch gekennzeichnet, daß die Polarisierungsmittel (18, 19, 20, 21) ein magnetisches Feld mit in bezug auf einen Ruhewert regulierbarer Feldstärke erzeugen.

9. Vorrichtung nach Anspruch 8, dadurch gekennzeichnet, daß die den progressiven magneto-statischen Raumwellen eigene thermische Abweichungen durch die dem Ruhewert zugehörige thermische Abweichung kompensiert wird.

10. Vorrichtung nach Anspruch 9, dadurch gekennzeichnet, daß der Ruhewert durch den Mitteln zur Polarisierung der magnetischen Schicht (2) zugehörige permanente Magnete bestimmt wird.

11. Vorrichtung nach einem der vorstehenden Ansprüche, dadurch gekennzeichnet, daß die nichtmagnetische Schicht (1) aus Gadolinium-Gallium-Granat besteht, während die magnetische Schicht (2) eine epitaxial in flüssiger Phase auf die nichtmagnetische Schicht (1) aufgebrachte Yttrium-Einsengranatschicht ist.

12. Vorrichtung nach einem der vorhergehenden Ansprüche, dadurch gekennzeichnet, daß die Netze (10, 11, 12, 13, 14) durch ionische Bearbeitung der Oberfläche der magnetischen Schicht (2) erzeugt sind.

13. Vorrichtung nach einem der vorhergehenden Ansprüche, dadurch gekennzeichnet, daß die Netze (10, 11, 12, 13, 14) durch ionische Einpflanzung in die magnetische Schicht (2) erzeugt sind.

14. Vorrichtung nach Anspruch 13, dadurch gekennzeichnet, daß die Netze vermittels selektiver Ätzung in Reliefform erzeugt werden.

15. Vorrichtung nach einem der Ansprüche 1 bis 11, dadurch gekennzeichnet, daß die Netze vermittels Ätzung durch ein Maskensieb hindurch erzeugt sind.

## Claims

1. Tunable selective magnetostatic space wave device, comprising a magnetic layer (2) supported by a non magnetic substrate (1), means for polarizing said layer (2) perpendicularly to its free surface, two resonant network recesses (10, 12, 11, 13) formed on said magnetic layer (2), and two microtapes (6, 7) provided each in a respective one of said resonant recesses, so as to constitute the electric input (4) and output (5) terminals of said device, characterized in that the respective axes of said resonant network recesses (10, 12, 11, 13) intersect in a zone of said layer (2) which includes an energy reflecting network (14) the element (16) of which are adapted to reflect a maximum amount of incident energy at the tuning frequency of said device, each resonant network recess (10, 11, 12, 13) comprising a reflecting end network (10, 11) and a semi-reflecting network (12, 13) interposed between said energy reflecting network (14) and the corresponding reflecting end network (10, 11).

2. Device according to claim 1, characterized in that the axes of said recesses include between them an angle $\theta$, the pitch $p_2$ of said energy reflecting network (14) being equal to $\lambda/2 \cos \theta/2$, wherein $\lambda$ represents the tuning wave length of said resonant recesses, the elements (16) of said reflecting network being aligned in accordance with the outer bisector of angle $\theta$.

3. Device according to claim 2, characterized in that said angle $\theta$ is equal to $\pi/2$.

4. Device according to any one of claims 1 to 3, characterized in that the form factor d/p of said networks (10, 11, 12, 13, 14) is so selected as to increase the insertion losses at the wave lengths representing multiples of the tuning wave length $\lambda$ of daid recesses.

5. Device according to any one of claims 1 to 4, characterized in that said microtapes (6, 7) are bent in a loop-shaped manner (23) so as to form two rectilinear radiating elements spaced by $\lambda/2$.

6. Device according to any one of claims 1 to 5, characterized in that said recesses (10, 11, 12, 13) have identical filtering characteristics.

7. Device according to any one of claims 1 to 5, characterized in that said recesses have distinct multi-mode filtering characteristics with a common resonance mode.

8. Device according to any one of claims 1 to 7, characterized in that said polarization means (18, 19, 20, 21) generate a magnetic field having an intensity adjustable with respect to a rest value.

9. Device according to claim 8, characterized in that the thermal drift inherent in progressive magnetostatic volume waves is compensated by the thermal drift associated to said rest value.

10. Device according to claim 9, characterized in that said rest value is determined by permanent magnets included in said means for polarizing said layer (2).

11. Device according to any one the preceding claims, characterized in that said non magnetic substrate (1) is constituted by gadolinium garnet, said layer (2) being an yttrium-iron-garnet layer epitaxially deposited in liquid phase onto the surface of said substrate (1).

12. Device according to any one the preceding claims, characterized in that said networks (10, 11, 12, 13, 14) are materialized by ionic treatment of the surface of said layer (2).

13. Device according to any one of the preceding claims, characterized in that said networks (10, 11, 12, 13, 14) are materialized by ionic implantation effected in said layer (2).

14. Device according to claim 13, characterized in that said networks are formed in relief by chemical attack.

15. Device according to any one of claims 1 to 11, characterized in that said networks are obtained by chemical attack through a mask.

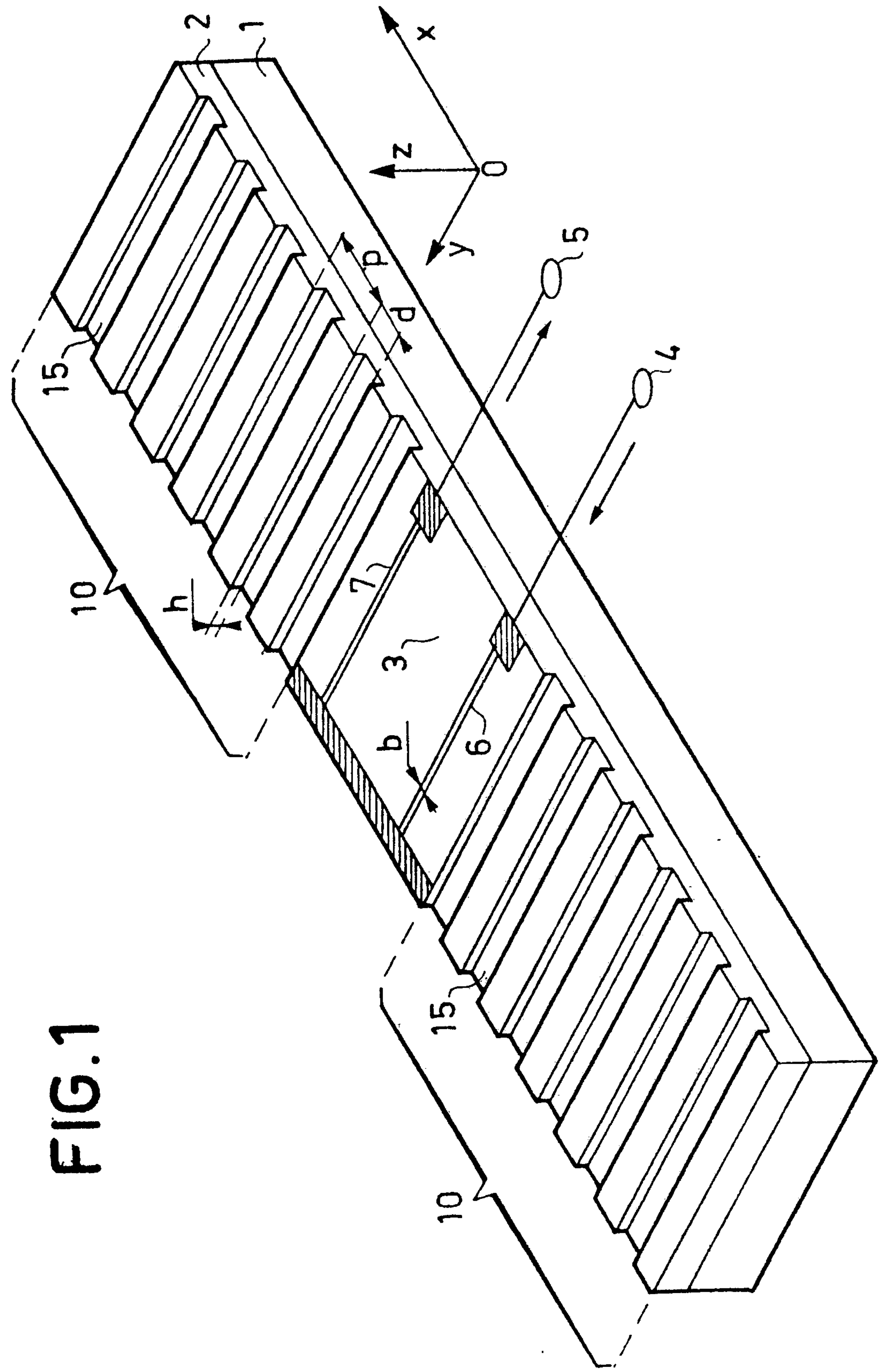


FIG.1

FIG.2

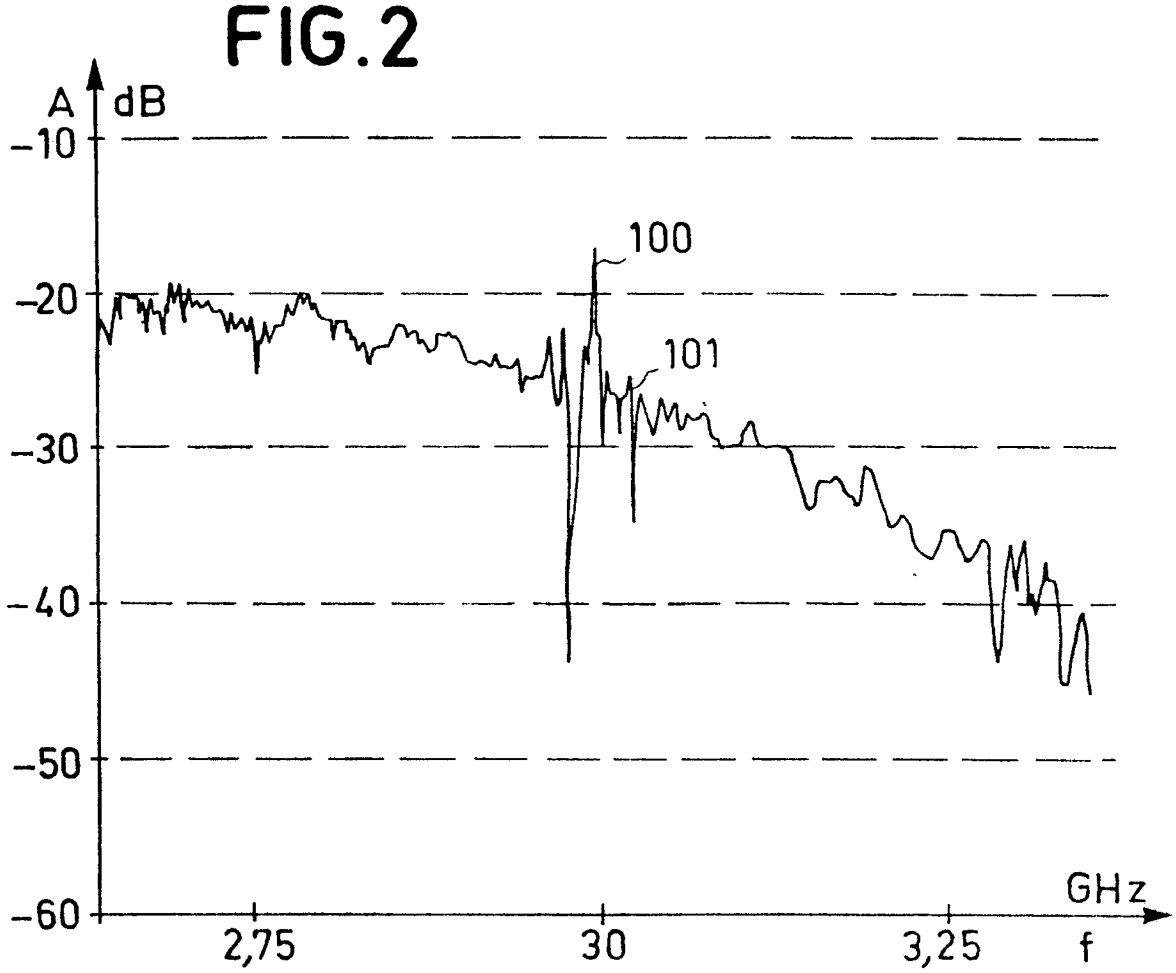
A dB
-10
-20
-30
-40
-50
-60
100
101
GHz
2,75
30
3,25
f

FIG.3

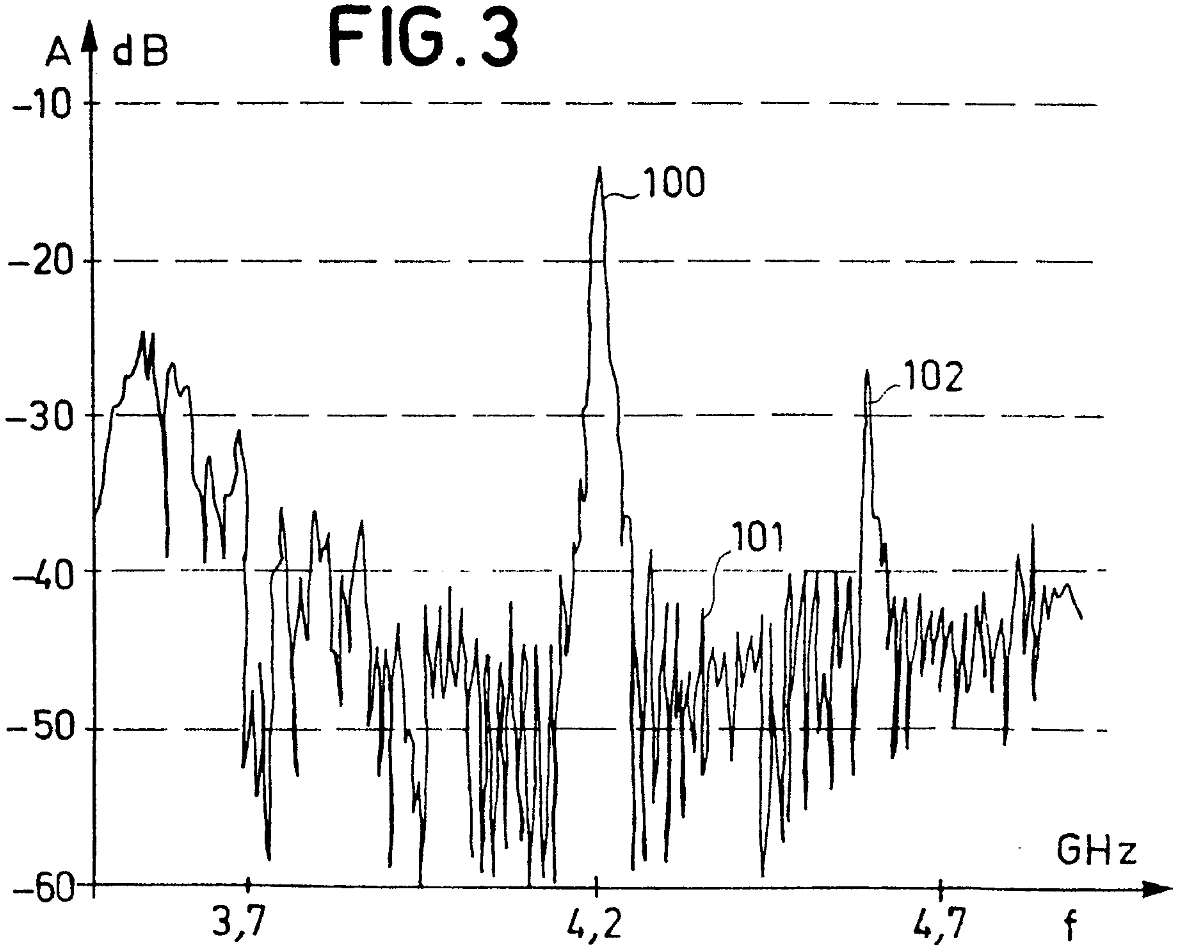
A dB
-10
-20
-30
-40
-50
-60
100
102
101
GHz
3,7
4,2
4,7
f

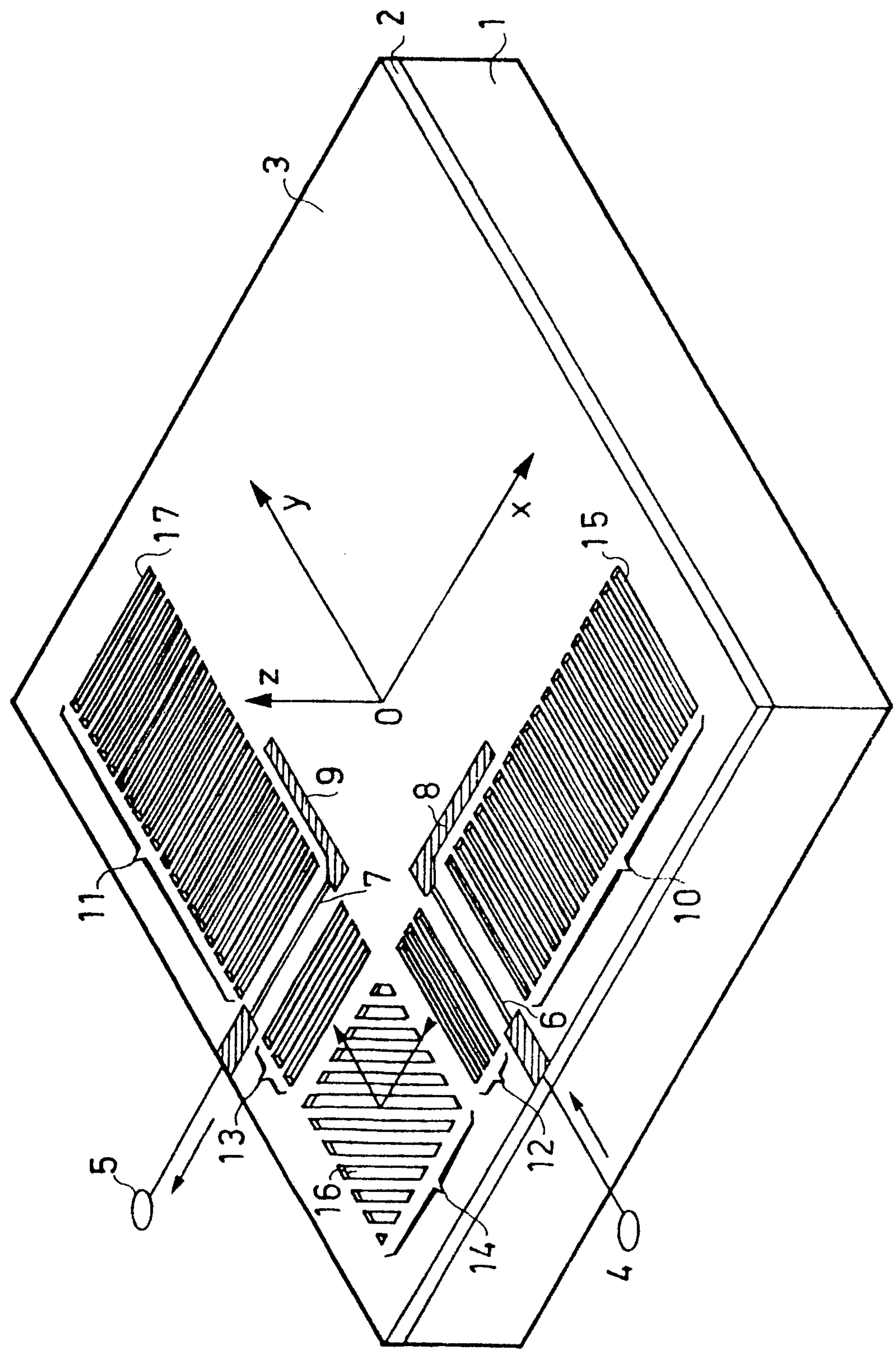


FIG. 4

FIG.5

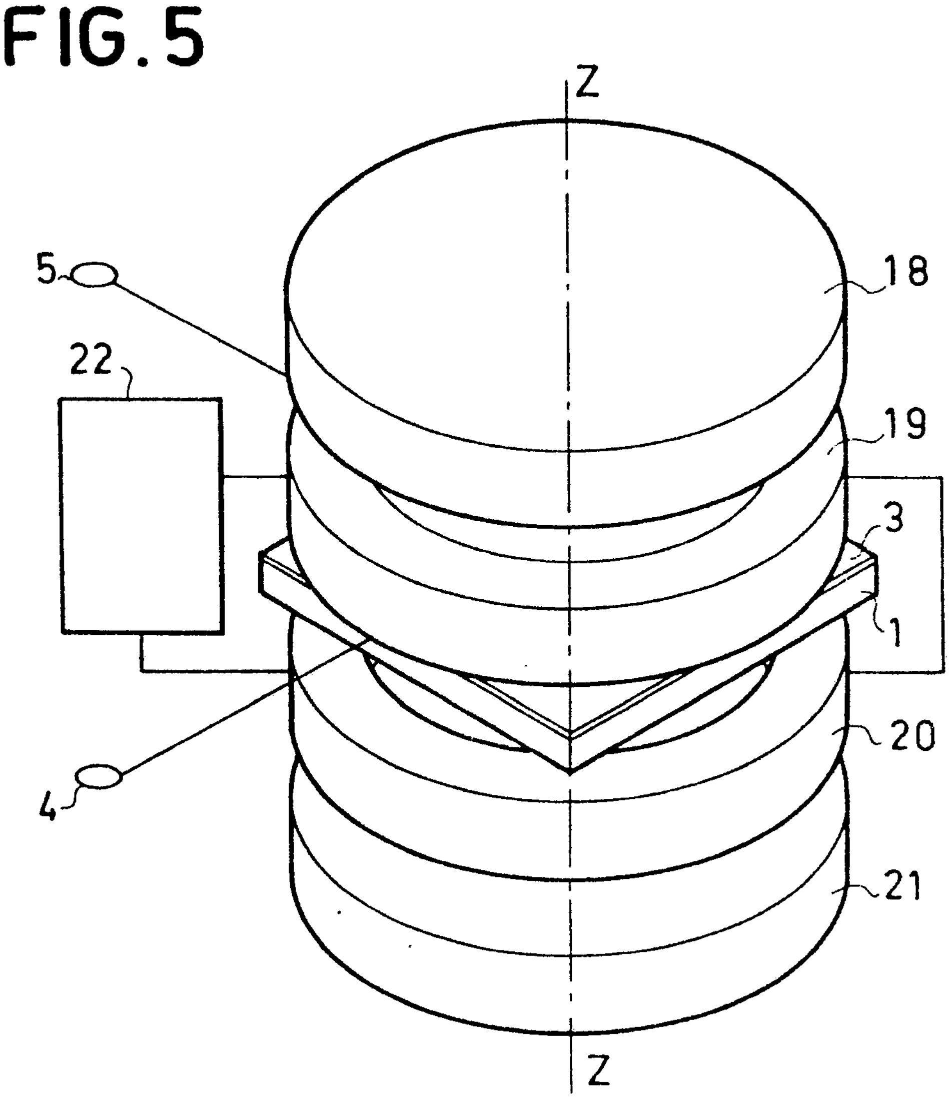


FIG.6